# EUROPÄISCHE PATENTSCHRIFT

(11) **EP 0 871 813 B1**
(45) Veröffentlichungstag und Bekanntmachung des Hinweises auf die Patenterteilung: **12.03.2003**
(21) Anmeldenummer: 97910599.6
(22) Anmeldetag: 06.11.1997
(51) Int. Cl.: E05B 47/00, B65D 43/20

(54) **VERSCHLUSSVORRICHTUNG**
LOCKING DEVICE
DISPOSITIF DE FERMETURE

(30) Priorität: 07.11.1996 DE 19646009
(43) Veröffentlichungstag der Anmeldung: 21.10.1998
(73) Patentinhaber: Sphinx Electronics GmbH & Co KG, 79341 Kenzingen (DE)
(72) Erfinder: KHWA, Peng, Teok, Singapur 730 328 (SG)
(74) Vertreter: Prietsch, Reiner, Dipl.-Ing.
(86) Internationale Anmeldenummer: IB9701460
(87) Internationale Veröffentlichungsnummer: WO98020220

(56) Entgegenhaltungen:
- EP-A- 0 484 294
- CH-A- 308 522
- DE-U- 9 206 641
- DE-U- 29 608 923
- FR-A- 2 086 962
- GB-A- 174 156
- GB-A- 2 282 636
- US-A- 1 628 525
- US-A- 3 837 525
- US-A- 4 848 812

## Beschreibung

Die Erfindung betrifft ein Gehäuse der im Oberbegriff des Anspruches 1 angegebenen Gattung.

Ein solches Gehäuse mit Verschlußvorrichtung ist aus der FR 2 086 962 bekannt. Die Verschlußvorrichtung kann nur von mit deren Funktionsprinzip vertrautem Personal mittels eines auf den Deckel aufgesetzten Permanent- oder Elektromagneten geöffnet werden, der gegensinnig zu dem permanentmagnetischen Sperrstift magnetisiert ist. Ein Gehäuse mit dieser Verschlußvorrichtung eignet sich für sicherheitstechnische Einrichtungen, die vor Manipulationen geschützt werden sollen, z.B. für Schlösser an Spind- oder Glastüren, sowie als Apparategehäuse. Da die Verschlußvorrichtung keine Gehäusedurchbrechungen erfordert, kann das Gehäuse mit geringem Aufwand wasserdicht oder zumindest spritzwasserfest gemacht werden.

Diese bekannte Verschlußvorrichtung hat jedoch den Nachteil, daß ein normaler Schiebedeckel über seine gesamte Länge aus dem Unterteil gezogen werden muß, um an die geschützten Einrichtungen zu gelangen. Somit ist ein relativ großer Einbauraum erforderlich.

Aus der DE 296 08 923 U ist es zwar bekannt, bei einem Gehäuse, das aus einer Grundplatte und einer auf diese aufschiebbaren und sie überdeckenden Haube besteht, die von der Haube wegweisend abgewinkelten Seitenränder der Grundplatte mit L-förmigen Schlitzen zu versehen, von denen jeder in eine schlüssellochartige Ausnehmung in der Grundplatte selbst übergeht, während die Haube korrespondierende, nach innen gerichtete Bolzen mit verbreitertem Kopf aufweist. Dies ermöglicht eine bajonettverschlußartige Verriegelung der Haube auf der Grundplatte, zunächst durch Aufsetzen und anschließend durch Verschieben der Haube in der Ebene der Grundplatte, hat aber den Nachteil, daß an der Querseite stets ein Spalt mit einer Breite gleich dem Verschiebeweg zwischen der Grundplatte und der Haube verbleibt. Dieser Spalt muß anderweitig, nämlich durch Montage der Grundplatte z.B. an einer Wand, abgedeckt werden.

Der Erfindung liegt die Aufgabe zugrunde, ein Gehäuse der einleitend angegebenen Gattung so weiterzuentwickeln, daß es nur einen kleinen Einbauraum benötigt.

Diese Aufgabe ist erfindungsgemäß dadurch gelöst, daß der Deckel an zwei gegenüberliegenden Längsrändern jeweils wenigstens zwei voneinander beabstandete, seitlich vorspringende Zungen hat, während das Unterteil in den entsprechenden Seitenwänden mit an die Abmessungen der Zungen angepaßten Ausnehmungen versehen ist, an welche sich in Schließrichtung des Deckels die Schiebenuten anschließen, die dessen Zungen aufnehmen.

Zum Öffnen des Gehäuses muß der Deckel nicht über die volle Länge des Unterteils sondern nur soweit herausgezogen werden, bis die Zungen des Deckels mit den Ausnehmungen in den Seitenwänden des Unterteils fluchten. Der Deckel kann dann rechtwinklig zu seiner Großfläche von dem Unterteil abgehoben werden. Im geschlossenen Zustand ist das Gehäuse wie dasjenige nach der FR 2 086 962 spritzwasserfest und mit geringem zusätzlichen Aufwand wasserdicht.

Damit der Sperrstift beim Abnehmen des erfindungsgemäß ausgebildeten Deckels in der Vorrichtung verbleibt, ist er zweckmäßig unverlierbar in einer antimagnetischen Führungshülse aufgenommen. Die Führungshülse kann einstückig mit einem in das Unterteil einschiebbaren antimagnetischen Steg sein. Das zuletzt genannte Merkmal ist insbesondere in herstell- und montagetechnischer Hinsicht vorteilhaft.

Bei einer speziellen Ausführungsform ist die bei geschlossenem Deckel von dem Sperrstift hintergriffene Sperrschulter an der Innenseite des Deckels als zur Deckelfläche rechtwinklige Flanke eines in Richtung des Gehäuseinnenraums vorspringenden Nockens ausgebildet.

Es ist zweckmäßig, eine Keilfläche vorzusehen, die beim Einschieben des Deckels den Sperrstift in das Unterteil zurückdrückt, bis die Sperrschulter den Sperrstift überfahren hat. Hierzu kann entweder die, bezogen auf die Einschieberichtung, vordere Kante des Deckels oder die freie Stirnfläche des Sperrstiftes keilförmig ausgebildet sein. Im letzteren Fall muß der Sperrstift allerdings verdrehgesichert geführt sein. Hierzu kann er einen vom Kreisquerschnitt abweichenden Querschnitt haben. Sofern der Sperrstift mit einem Nocken zusammenwirkt, kann statt dessen dieser eine in Einschieberichtung vorlaufende Keilfläche haben, die den Sperrstift in das Unterteil zurückdrückt, bis die Nockenflanke den Sperrstift überfahren hat.

Um die Verschlußvorrichtung bequem und rasch in die Entsperrstellung zu bringen, ist zweckmäßigerweise auf den Deckel eine Entsperrplatte mit mindestens zwei mit dem Gehäuse zusammenwirkenden Positioniermitteln und einem gegensinnig zu der Magnetisierungsrichtung des Sperrstiftes angeordneten Permanentmagneten aufsetzbar. Bei einem rechteckigen oder quadratischen Gehäuse können die Positioniermittel aus zwei an die Entsperrplatte angeformten Laschen bestehen, die so angeordnet sind, daß bei Anlage an zwei zueinander rechtwinklige Seitenwände des Unterteils der Permanentmagnet der Platte sich genau über dem permanentmagnetischen Sperrstift befindet. Die Positioniermittel können aber auch beispielsweise aus zwei oder mehr an der Platte ausgebildeten Nasen bestehen, die in der richtigen Stellung der Entsperrplatte in in der Außenfläche des Deckels vorgesehene, komplementäre Vertiefungen zu liegen kommen.

Wie sich von selbst versteht, wird man die vorgeschlagene Verschlußvorrichtung in der Regel mit mehr als einem permanentmagnetischen Sperrstift ausstatten, denn ein einzelner Sperrstift ist anhand seines Magnetfeldes auch von einem Unbefugten leicht zu orten. Verwendet man hingegen mehrere Sperrstifte, die dann teils gleichsinning zueinander, teils gegensinning zueinander magnetisiert eingebaut sind, so ist es ohne eine passende Entsperrplatte fast unmöglich, alle Sperrstifte gleichzeitig in ihre Freigabestellung zurückzudrücken. Des weiteren können mit mehreren Sperrstiften nach dem in der Schließtechnik bekannten Prinzip Verschlußvorrichtungen mit unterschiedlichen Codierungen bereitgestellt sowie Familien geschaffen und Hierarchien definiert werden.

Die den Sperrstift in Richtung des Deckels belastende Kraft kann wahlweise durch eine in der Führungshülse angeordnete Schraubendruckfeder oder durch einen gegensinnig zur Magnetisierungsrichtung des Sperrstiftes wirkenden Permanentmagnet erzeugt werden. Letzterer hat gegenüber der Verwendung einer Schraubendruckfeder den Vorteil einer größeren Korrosionsbeständigkeit, soweit das Gehäuse in Feucht- oder Naßräumen verwendet wird oder der Witterung ausgesetzt ist.

Die Verschlußvorrichtung nach der Erfindung wird nachfolgend anhand der Zeichnung erläutert, in der ein Ausführungsbeispiel dargestellt ist. Es zeigt:
- Fig. 1:: eine Explosionsdarstellung eines Gehäuses mit der vorgeschlagenen Verschlußvorrichtung,
- Fig. 2:: das Gehäuse mit geöffnetem Deckel im Längsschnitt,
- Fig. 3:: den gleichen Längsschnitt, jedoch mit vollständig geschlossenem Gehäuse und über dem Deckel angeordneter Entsperrplatte,
- Fig. 4:: einen vergrößerten Teilschnitt in Höhe eines Sperrstiftes in dessen Sperrstellung,
- Fig. 5:: den gleichen Schnitt wie Figur 4, jedoch mit dem Sperrstift in Freigabestellung und
- Fig. 6:: den gleichen Schnitt wie Figur 4, jedoch in einer anderen Ausführungsform der Sperrschulter.

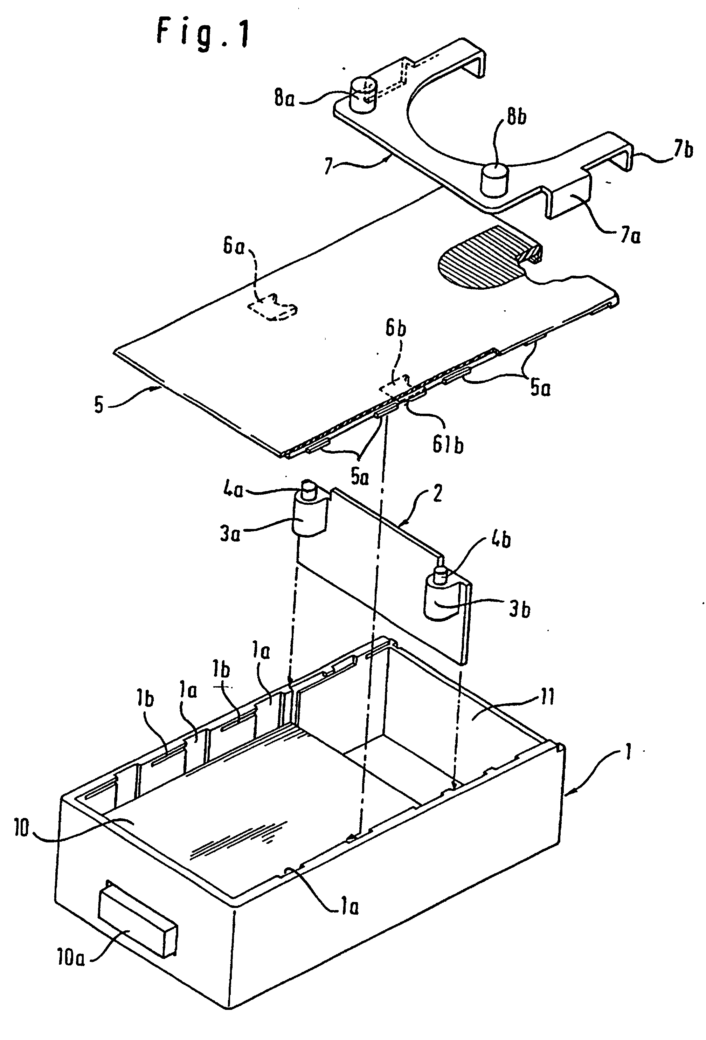

Die Figuren 1 bis 3 zeigen ein Gehäuse, bestehend aus einem Unterteil 1, einem Quersteg 2 mit zwei angeformten Hülsen 3a, 3b zur Aufnahme von zwei Sperrstiften 4a, 4b, einem Deckel 5 mit unterseitigen Nocken 6a, 6b und einer Entsperrplatte 7, die zwei Entsperrmagnete 8a und 8b trägt Mit Ausnahme der letzteren und der zwei Sperrstifte 4a, 4b bestehen alle Teile aus antiferromagnetischen Werkstoffen.

Der Schiebedeckel 5 hat an seinen Längsrändern fünf vorspringende Zungen 5a, denen an den Innenseiten der Seitenwände des Unterteils 1 Ausnehmungen 1a entsprechen. An diesen Ausnehmungen 1a schließen sich in Schieberichtung des Deckels 5 Schiebenuten 1b an.

Das Gehäuse kann zum Beispiel das angedeutete Schloß 10 mit Riegel 10a aufnehmen. Hinter dem Quersteg 2 verbleibt in dem Gehäuse ein Raum 11, zum Beispiel zur Aufnahme von Batterien sowie einer Steuerelektronik für das Schloß 10.

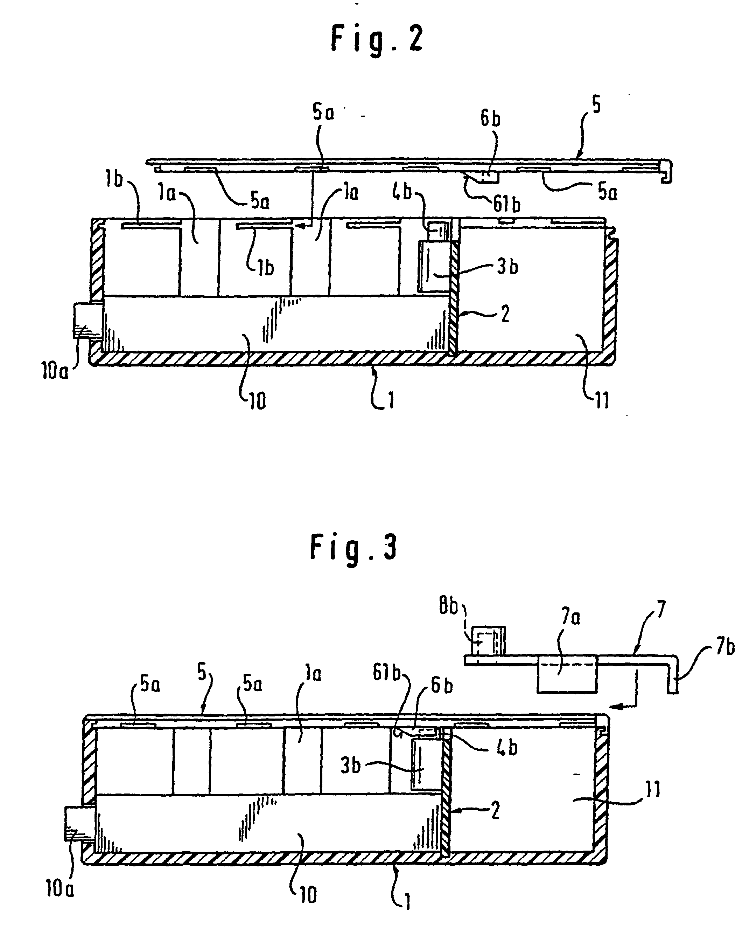

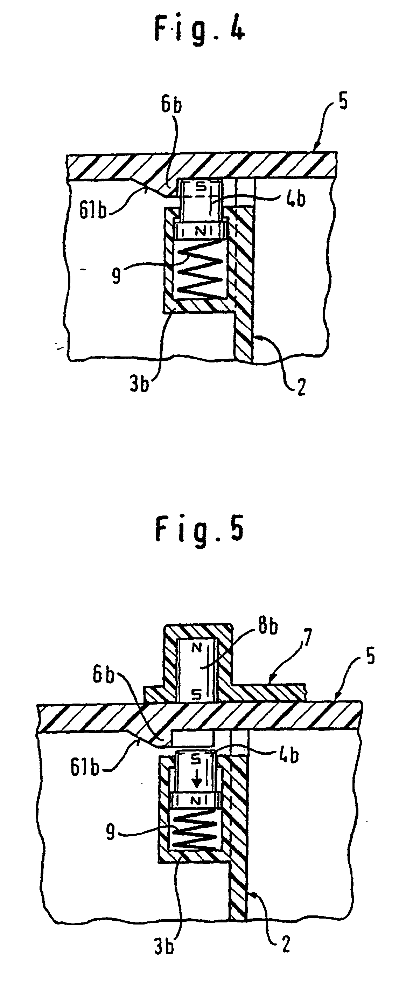

Figur 2 zeigt den Deckel 5 in der Stellung, in der er auf das Unterteil 1 aufgesetzt wird, wenn das Gehäuse geschlossen werden soll. Nach dem Aufsetzen auf das Unterteil 1, während der Deckel 5 dann zum Schließen des Gehäuses nach links geschoben wird, drückt der Nocken 6b mit seiner vorlaufenden Keilfläche 61b den Stift 4b gegen die Kraft einer Feder 9 (vgl. Figur 4 und 5) in seine Hülse 3b zurück, bis die rückwärtige, halbkreisförmig ausgenommene Flanke des Nockens 6b diesen Stift 4b vollständig überlaufen hat. Die entsprechende Sperrstellung zeigt Figur 4.

In dem in Figur 3 dargestellten, geschlossenen Zustand hintergreift der Stift 4b dann den Nocken 6b. Zum Öffnen wird eine Entsperrplatte 7 so auf den Deckel 5 aufgesetzt, daß die angeformten Lappen 7a und 7b an den entsprechenden Seitenwänden des Gehäuses anliegen. Dann befindet sich, wie Figur 5 zeigt, der Permanentmagnet 8b der Platte 7 genau über dem Sperrstift 4b in der Hülse 3b und drückt wegen seiner gegensinnigen Magnetisierungsrichtung den Sperrstift 4b in die Freigabestellung.

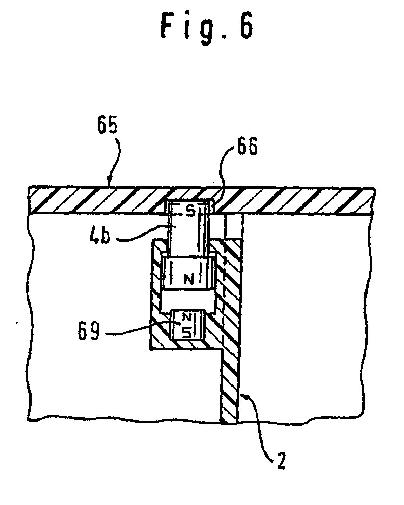

Figur 6 zeigt eine andere Ausführungsform, bei der die den Sperrstift 4b in die Sperrstellung drückende Kraft nicht mittels einer Schraubendruckfeder sondern mittels eines in die Hülse 3b eingegossenen oder eingeklebten, gegensinnig polarisierten Permanentmagneten 69 erzeugt wird. Des weiteren weist der Deckel 65 statt der Nocken 6a, 6b Sacklöcher 66 auf, in die der Sperrstift 4b in der Sperrstellung eingreift. Da in diesem Fall der Abstand zwischen dem Sperrstift 4b und dem Entsperrmagneten 8b (vgl. Figur 5) in der Entsperrplatte 7 deutlich kleiner als bei der zuvor beschriebenen Ausführungsform ist, können im Vergleich dazu als Permanentmagnete in der Entsperrplatte 7 solche mit geringerer Induktion und somit aus einem preiswerteren permanentmagnetischen Werkstoff verwendet werden.

## Patentansprüche

1. Gehäuse, mit einem Unterteil (1) und einem Schiebedeckel (5; 65) aus antimagnetischem Werkstoff und einer Verschlußvorrichtung, umfassend mindestens einen in dem Unterteil (1) rechtwinklig zur Ebene des Dekkels (5; 65) verschiebbaren, in Richtung des Delkels belasteten, permanentmagnetischen Sperrstift (4a, 4b), der bei geschlossenem Deckel eine an dessen Innenseite ausgebildete Sperrschulter (6a, 6b; 66) hintergreift, **dadurch gekennzeichnet, daß** der Deckel (5) an zwei gegenüberliegenden Längsrändern jeweils wenigstens zwei voneinander beabstandete, seitlich vorspringende Zungen (5a) hat, und daß das Unterteil in den entsprechenden Seitenwänden mit jeweils der Tiefe und Breite einer Zunge (5a) entsprechenden Ausnehmungen (1a) versehen ist, an die sich in Schließrichtung des Deckels dessen Zungen aufnehmende Schiebenuten (1b) anschliessen.

2. Gehäuse nach Anspruch 1, **dadurch gekennzeichnet, daß** der Sperrstift (4a, 4b) unverlierbar in einer antimagnetischen Führungshülse (3a, 3b) aufgenommen ist und die Führungshülse (3a, 3b) einstückig mit einem in das Unterteil einschiebbaren, antimagnetischen Steg (2) ist.

3. Gehäuse nach Anspruch 1 oder 2, **dadurch gekennzeichnet, daß** die Sperrschulter an der Innenseite des Dekkels (5) aus einer zur Deckelfläche rechtwinkligen Flanke eines in Richtung des Gehäuseinnenraums vorspringenden Nockens (6a, 6b) besteht.

4. Gehäuse nach Anspruch 3, **gekennzeichnet durch** eine Keilfläche (61b) an dem Deckel (5), die bei dessen Einschieben den Sperrstift (4b) in das Unterteil (1) zurückdrückt, bis die Nockenflanke den Sperrstift (4b) überfahren hat.

5. Gehäuse nach einem der Ansprüche 1 bis 4, **dadurch gekennzeichnet, daß** auf den Deckel (5; 65) eine Entsperrplatte (7) mit mindestens zwei mit dem Gehäuse zusammenwirkenden Positioniermitteln (7a, 7b) und einem gegensinnig zu der Magnetisierungsrichtung des Sperrstiftes angeordneten Permanentmagneten (8a, 8b) aufsetzbar ist.

6. Gehäuse nach einem der Ansprüche 1 bis 5, **gekennzeichnet durch** mehrere Sperrstifte, die teils gleichsinnig zueinander, teils gegensinnig zueinander magnetisiert sind.

7. Gehäuse nach einem der Ansprüche 2 bis 6, **dadurch gekennzeichnet, daß** in der Führungshülse ein gegensinnig zur Magnetisierungsrichtung des Sperrstiftes (4b) wirkender Permanentmagnet (69) angeordnet ist.

## Claims

1. A casing comprising a bottom portion (1) and a sliding cover (5; 65) of nonmagnetic material and a closure device, including at least one permanent-magnetic locking pin (4a, 4b) which is displaceable in the bottom portion (1) at a right angle to the plane of the cover (5; 65) and which is loaded in the direction of the cover and which when the cover is closed engages behind a locking shoulder (6a, 6b; 66) at the inside thereof, **characterised in that** at two oppositely disposed longitudinal edges the cover (5) respectively has at least two mutually spaced, laterally projecting tongues (5a), and that in the corresponding side walls the bottom portion is provided with respective recesses (1a) which correspond to the depth and width of a tongue (5a) and which are adjoined in the closing direction of the cover by sliding grooves (1b) for accommodating the tongues thereof.

2. A casing according to claim 1 **characterised in that** the locking pin (4a, 4b) is non-detachably accommodated in a nonmagnetic guide sleeve (3a, 3b) and the guide sleeve is in one piece with a nonmagnetic bar (2) which can be pushed into the bottom portion.

3. A casing according to claim 1 or claim 2 **characterised in that** the locking shoulder at the inside of the cover (5) comprises a flank, which is at a right angle to the surface of the cover, of a projection (6a, 6b) projecting in the direction of the internal space in the casing.

4. A casing according to claim 3 **characterised by** a wedge surface (61b) on the cover (5), which upon insertion thereof pushes the locking pin (4b) back into the bottom portion (1) until the flank of the projection has travelled over the locking pin (4b).

5. A casing according to one of claims 1 to 4 **characterised in that** an unlocking plate (7) can be fitted on to the cover (5; 65), the unlocking plate having at least two positioning means (7a, 7b) co-operating with the casing and a permanent magnet (8a, 8b) arranged in the opposite direction to the direction of magnetisation of the locking pin.

6. A casing according to one of claims 1 to 5 **characterised by** a plurality of locking pins which are magnetised in part in the same direction as each other and in part in opposite directions to each other.

7. A casing according to one of claims 2 to 6 **characterised in that** disposed in the guide sleeve is a permanent magnet (69) acting in opposite relationship to the direction of magnetisation of the locking pin (4b).

## Revendications

1. Boîtier avec une partie inférieure (1), un couvercle coulissant (5 ; 65) en matériau antimagnétique et un dispositif de fermeture, comprenant au moins un doigt de blocage (4a, 4b) à aimantation permanente, précontraint en direction du couvercle et mobile en translation dans la partie inférieure (1) perpendiculairement au plan du couvercle (5 ; 65), ledit doigt de blocage s'engageant, lorsque le couvercle est fermé, derrière un épaulement de blocage (6a, 6b ; 66) formé sur la face interne dudit couvercle, **caractérisé en ce que** le couvercle (5) possède, sur chacun de ses deux bords longitudinaux opposés, au moins deux languettes (5a) en saillie latérale et distantes l'une de l'autre et **en ce que** la partie inférieure est dotée, au niveau des parois latérales correspondantes, d'évidements (1a) correspondant en profondeur et en largeur auxdites languettes (5a), lesdits évidements se prolongeant, dans la direction de fermeture du couvercle, par des rainures de guidage (1b) recevant les languettes dudit couvercle.

2. Boîtier selon la revendication 1, **caractérisé en ce que** le doigt de blocage (4a, 4b) est logé imperdable dans une douille de guidage antimagnétique (3a, 3b) et **en ce que** la douille de guidage (3a, 3b) est formée d'un seul tenant avec une barrette antimagnétique (2) apte à être insérée dans la partie inférieure.

3. Boîtier selon la revendication 1 ou 2, **caractérisé en ce que** l'épaulement de blocage formé sur la face interne du couvercle (5) consiste en un flanc, perpendiculaire à la surface du couvercle, d'une came (6a, 6b) faisant saillie en direction de l'intérieur du boîtier.

4. Boîtier selon la revendication 3, **caractérisé par** une surface formant rampe (61b) sur le couvercle (5), qui, lors de l'insertion dudit couvercle, repousse le doigt de blocage (4b) dans la partie inférieure (1) jusqu'à ce que les flancs des cames aient dépassé le doigt de blocage (4b).

5. Boîtier selon l'une des revendications 1 à 4, **caractérisé en ce que** peut être rapportée sur le couvercle (5 ; 65) une plaque de déblocage (7) présentant au moins deux moyens de positionnement (7a, 7b), qui coopèrent avec le boîtier, et un aimant permanent (8a, 8b) dont l'aimantation est orientée dans le sens inverse de l'aimantation du doigt de blocage.

6. Boîtier selon l'une des revendications 1 à 5, **caractérisé par** une pluralité de doigts de blocage aimantés en partie dans le même sens et en partie en sens inverse.

7. Boîtier selon l'une des revendications 2 à 6, **caractérisé en ce qu'**un aimant permanent (69) agissant dans le sens inverse de l'aimantation du doigt de blocage (4b) est agencé dans la douille de guidage.
